# EUROPÄISCHE PATENTSCHRIFT

(11) **EP 0 360 919 B1**
(45) Veröffentlichungstag und Bekanntmachung des Hinweises auf die Patenterteilung: **20.12.1995**
(21) Anmeldenummer: 88116235.8
(22) Anmeldetag: 30.09.1988
(51) Int. Cl.: H03M 1/10, H03M 1/46, H03M 1/80

(54) **Verfahren zur Bestimmung und Verarbeitung von Korrekturwerten für selbstkalibrierende A/D- und D/A-Wandler und Rechenwerk zur Durchführung des Verfahrens**
Method for determining and processing correction values for autocalibrating A/D and D/A converters, and calculating unit for carrying out the method
Procédé de détermination et de traitement de valeurs de correction pour des convertisseurs A/N et N/A à auto-étalonnage et unité de calcul pour la mise en fonction du procédé

(43) Veröffentlichungstag der Anmeldung: 04.04.1990
(73) Patentinhaber: SIEMENS AKTIENGESELLSCHAFT, 80333 München (DE)
(72) Erfinder: Kuttner, Franz, Dipl.-Ing., A-9500 Villach (AT)

(56) Entgegenhaltungen:
- US-A- 4 451 821
- IEEE TRANSACTIONS ON CIRCUITS AND SYSTEMS, Band CAS-30, Nr. 3, März 1983, Seiten 188-180, IEEE; H.-S. LEE et al.: "Self-calibration technique for A/D converters"

## Beschreibung

Die Erfindung betrifft ein Verfahren zur Bestimmung und Verarbeitung von Korrekturwerten für selbstkalibrierende A/D- und D/A-Wandler nach dem Oberbegriff des Patentanspruchs 1 und ein Rechenwerk zur Durchführung des Verfahrens gemäß dem 0berbegriff des Patentanspruchs 3.

Die wichtigste und kritischste Schnittstelle zwischen verschiedenen Typen von Systemen ist gewöhnlich die Verbindung zwischen analogen und digitalen Teilen der Systeme. Die Schnittstelle zwischen einem digitalen Kreis und einem analogen Kreis benötigt dabei einen D/A-Wandler, während die Schnittstelle zwischen einem analogen Kreis und einem digitalen Kreis ensprechend einen A/D-Wandler erfordert. Mit einem A/D-Wandler läßt sich ein D/A-Wandler aufbauen und umgekehrt. Ein natürlich real nicht existirender idealer Wandler setzt ein digitales bzw. analoges Signal ohne Verzögerung und ohne Fehler in ein analoges bzw. digitales Signal um.

Bei vielen Typen von A/D- und D/A-Wandlern benötigt man Referenzelemente, die aus einer vorgegebenen Referenzgröße weitere Größen ableiten, die für eine Umsetzung benötigt werden. Diese Referenzelemente bilden ein gewichtetes Netzwerk. In der Praxis werden die gewichteten Netzwerke meistens durch Widerstände, Kondensatoren oder Transistoren realisiert. Derartige Wandler arbeiten beispielsweise nach dem Verfahren der sukzessiven Aproximation, für die als ein Vertreter ein Wandler mit Ladungsverteilung (Charge Redistribution) gelten kann, bei dem das gewichtete Netzwerk aus Kapazitäten besteht. Bei Wandlern mit gewichtetem Netzwerk ist es wichtig, daß die gewichteten Elemente zueinander in einem genau vorgegebenen Verhältnis stehen. Für hochgenaue Wandler müssen die gewichteten Elemente hochgenau sein. Probleme ergeben sich jedoch, weil die gewichteten Elemente nicht genau genug hergestellt werden können. Üblicherweise erfolgt deshalb eine Korrektur, beispielsweise durch Trimmverfahren oder durch die Verwendung von Festwertspeichern, die jedoch Nachteile aufweisen.

Eine weitere Möglichkeit zur Kalibrierung von A/D- bzw. D/A-Wandlern besteht in der Möglichkeit der Selbstkalibrierung und ist beispielsweise aus der US-PS 4,451,821 (Domogalla) und der Veröffentlichung von H.-S. Lee und D. Hodges "Self-Calibration Technique for A/D-Converters", IEEE Transactions on Circuits and Systems, Vol. CAS-30, No. 3, March 1983, p. 188 bekannt.

Die beschriebenen Selbstkalibrierverfahren der sukzessiven Approximation setzen ein binär gewichtetes Netzwerk voraus, bei dem das kleinste Elemente doppelt vorhanden ist. Dann ist im Idealfall ein gewichtetes Elemente identisch gleich der Summe aller niedriger gewichteten Elemente (Bits). Bei dieser Selbstkalibrierung wird das Verhältnis der Referenzelemente zueinander während der Kalibrierung gemessen und in Werte umgerechnet, mit denen die Referenzelemente korrigiert werden können.

Bei den häufig eingesetzten selbstkalibrierenden Wandlern mit kapazitivem Wandlernetzwerk wird dazu schrittweise für jede Kapazität des Netzwerks die Abweichung von der Summe der Kapazitäten aller niedriger gewichteten Kapazitäten festgestellt. Selbstkalibrierende Wandler sind allerdings nicht nur mit kapazitiven, sondern auch anderen Netzwerkselementen möglich. Aus dieser Differenz, die idealerweise Null ist, kann offensichtlich der jeder Kapazität zuzuordnende Gewichtungsfehler bestimmt werden, der abgespeichert wird und dann bei einem Wandlungsvorgang zur Korrektur des Ergebnisses benutzt werden kann. Dieser Gewichtungsfehler wird üblicherweise mit Hilfe eines Kalibrier- und Korrekturnetzwerks ermittelt. Zur Zuordnung der Korrektur-Gewichtungen zu den einzelnen gewichteten Referenzelementen ist eine Recheneinheit erforderlich. Diese kann beispielsweise einen Microcomputer enthalten, der jedoch oftmals einen zu hohen Aufwand darstellt. Eine andere Möglichkeit besteht in der Verwendung eines Rechenwerks.

Der Erfindung liegt die Aufgabe zugrunde, ein Verfahren zur Bestimmung und Verarbeitung von Korrekturwerten für selbstkalibrierende A/D- und D/A-Wandler anzugeben, das exakt arbeitet und vergleichsweise wenig Aufwand erfordert. Der Erfindung liegt weiterhin die Aufgabe zugrunde, ein Rechenwerk zur Durchführung des Verfahrens anzugeben.

Diese Aufgabe wird bei einem selbstkalibrierenden A/D- und D/A-Wandler der eingangs genannten Art erfindungsgemäß durch die Merkmale der kennzeichnenden Teile der Patentansprüche 1 und 3 gelöst.

Die Erfindung hat den Vorteil, daß die Korrekturwerte bereits in der Kalibrier- bzw. Wandlungsphase unmittelbar berücksichtigt und verarbeitet werden können. Bezüglich des Auftretens metastabiler Zustände ist Vorsorge getroffen. Daraus ergibt sich der weitere Vorteil, daß sich die Wandlergenauigkeit erheblich verbessern läßt. Die Erfindung ist nicht auf bestimmte selbstkalibrierende Wandler beschränkt.

Ausgestaltungen der Erfindung sind in Unteransprüchen gekennzeichnet.

Die Erfindung wird im folgenden anhand eines in den Figuren der Zeichnung dargestellten Ausführungsbeispiels näher erläutert.
- FIG 1: zeigt ein grundsätzliches Schemabild eines selbstkalibrierenden Wandlers mit kapazitivem Netzwerk und
- FIG 2: ein Ausführungsbeispiel eines erfindungsgemäßen Rechenwerks zur Durchführung des erfindungsgemäßen Verfahrens.

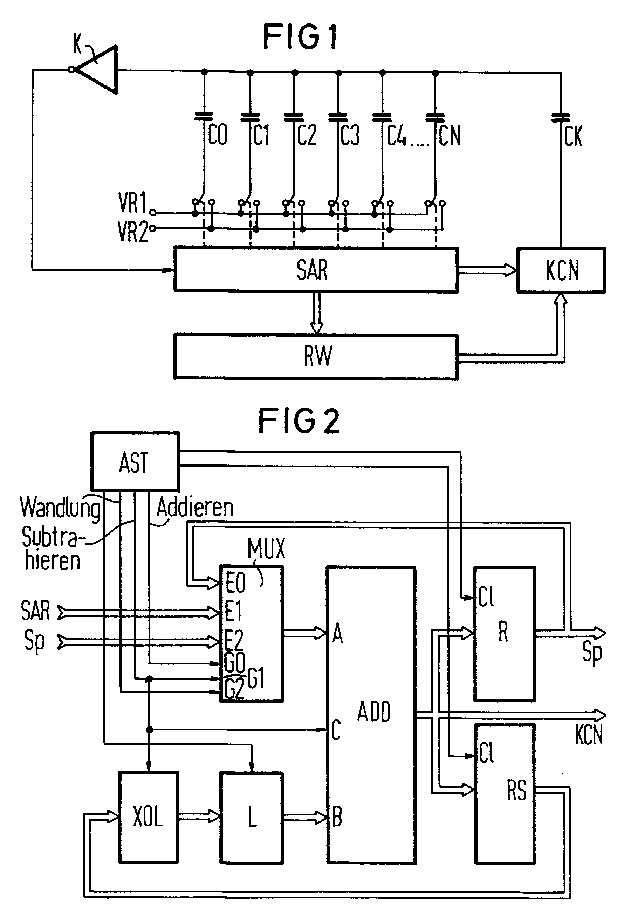

Gemäß FIG 1 besitzt der selbstkalibrierende Wandler ein kapazitiv gewichtetes Wandlernetzwerk, dessen Gewichtung binär ist. Das Netzwerk enthält die Kapazitäten Ci, wobei i die Werte von Null bis N durchläuft. Es gilt, daß C0 gleich groß wie C1 ist, so daß die kleinste Kapazität doppelt ausgeführt ist. Jeweils ein Anschluß der gewichteten Kapazitäten ist auf einen gemeinsamen Knotenpunkt und dieser auf einen Eingang eines Komparators K geführt. Der Ausgang des Komparators K steuert ein sukzessives Approximationsregister SAR, das seinerseits ein nicht bezeichnetes Schalternetzwerk steuert, mit dem die gewichteten Wandlerkapazitäten an Referenzpotentiale VR1 bzw. VR2 anschließbar sind. Dem sukzessiven Approximationsregister ist ein Rechenwerk RW nachgeschaltet, das zusammen mit dem sukzessiven Approximationsregister SAR ein Kalibrier- und Korrekturnetzwerk KCN steuert. Der Ausgang des Kalibrier- und Korrekturnetzwerks KCN ist über einen Koppelkondensator CK mit dem Knotenpunkt bzw. dem Komparatoreingang verbunden. Vorzugsweise enthält das Kalibrier- und Korrekturnetzwerk einen Kalibrier-D/A-Wandler, der ebenfalls ein gewichtetes Netzwerk enthält, beispielsweise ein Widerstandsnetzwerk oder vorzugsweise ein kapazitives Netzwerk.

Mit zunehmender Auflösung der A/D- und D/A-Wandler ergibt sich ein zunehmender Fehleranteil bei der Wandlung dadurch, daß die Kapazitäten nicht ideal zueinander gewichtet sind. Für das gewichtete Wandlernetzwerk gilt, daß eine Kapazität gleich der Summe aller kleineren Kapazitäten plus einem Fehlerterm ist. Auf diese Weise läßt sich ein Gleichungssystem aufstellen, bei dem C1 gleich C0 plus einem ersten Fehlerterm E1, C2 gleich der Summe aus C0, C1 und einem zweiten Fehlerterm E2 ist usw. Die Kapazität CN ist dann gleich der Summe aus den Kapazitäten C0 bis C (N - 1) plus einem Fehlerterm EN. Auf diese Weise ergeben sich N Gleichungen mit N Fehlertermen E1 bis EN, die bei Kalibrieren des Wandlers durch Vergleich jeder Kapazität des Wandlernetzwerks mit der Summe aller kleineren Kapazitäten mit Hilfe des Kalibrier- und Korrekturnetzwerks gemessen werden.

Aus diesen Fehlertermen müssen nun für jede gewichtete Kapazität Korrekturwerte ermittelt werden, die dann beim Wandlungsvorgang jedesmal, wenn die zugeordnete Kapazität ausgewählt wird, deren Kapazitätswert korrigieren soll. Der Korrekturwert für eine beliebige Kapazität wird dabei berechnet als die Hälfte der Differenz aus dem zugeordnetem Fehlerterm und der Summe aller Korrekturwerte für die höher gewichteten Kapazitäten. Auf diese Weise wird dabei zunächst der Korrekturwert KWN für die Kapazität CN bestimmt, der gleich dem halben Fehlerterm EN ist. Der Korrekturwert KW (N - 1) für die Kapazität C (N - 1) ergibt sich aus dem Fehlerterm E (N - 1) abzüglich des Korrekturwertes KWN für die Kapazität CN, wobei die Differenz durch 2 dividiert wird. Auf diese Weise werden sukzessive alle Korrekturwerte ermittelt und abgespeichert.

Während einer normalen Konversion arbeitet der Wandler wie ein normaler sukzessiver Approximations-Wandler, wobei jedoch mit dem Kalibrier- und Korrekturnetzwerk KCN je nach eingestelltem Bitmuster am gewichteten Wandlernetzwerk eine entsprechende Korrekturladung auf das kapazitive Wandlernetzwerk aufgebracht wird. Das Rechenwerk RW übernimmt dabei die Aufgabe, während der Kalibrierung die Korrekturwerte nach der angegebenen Formel zu berechnen und während der normalen Wandlung die Summe der Korrekturwerte zu berechnen.

Gemäß FIG 2 enthält das erfindungsgemäße Rechenwerk einen Addierer ADD, dem zwei Registerbänke, das Summenregister RS und ein weiteres Register R nachgeschaltet sind. Das Summenregister RS dient zur Zwischenspeicherung von Summen der Korrekturwerte und das weitere Register R als Zwischenspeicher für die einzelnen errechneten Korrekturwerte. Das Summenregister RS ist ausgangsseitig mit einem Buseingang B des Addierers ADD verbunden. Den Ausgängen des Summenregisters RS sind Exklusiv-ODER-Glieder XOL sowie ein Zwischenspeicher (Latch) L nachgeschaltet. Der Zwischenspeicher L ist von der Ablaufsteuerung AST steuerbar, so daß er ohne Speicherwirkung transparent geschaltet oder aber nicht transparent geschaltet werden kann und dann die Funktion Durchverbinden oder Zwischenspeichern erfüllt.

Ein weiterer Buseingang A des Addierers ADD wird mit Hilfe eines Multiplexers MUX angesteuert, mit dessen Hilfe wahlweise die Ausgänge des weiteren Registers R, die Ausgänge des sukzessiven Approximationsregisters SAR oder die Ausgänge eines nicht gezeichneten Speichers Sp jeweils als Bus auf den Addierer durchschaltbar sind. Die Ausgänge des weiteren Registers R führen weiterhin zu den Speichereingängen des nicht gezeichneten Speichers Sp. Die Ausgangsanschlüsse des Addierers ADD führen als Bus zum Kalibrier- und Korrekturnetzwerk KCN. Die Steuerung des Rechenwerks übernimmt eine Ablaufsteuerung AST, die einerseits die erforderlichen Taktsignale und andererseits die Steuersignale für den Multiplexer MUX und die Exklusiv-ODER-Glieder erzeugt. Der Multiplexer MUX schaltet dabei im Betrieb "Addieren" die Ausgänge des weiteren Registers R durch, im Betrieb "Subtrahieren" die Ausgänge des sukzessiven Approximationsregisters und im Betrieb "Wandlung" die Speicherausgänge des nicht gezeichneten Speichers SP. Beim Betrieb "Subtrahieren" werden dabei die Exklusiv-ODER-Glieder umgeschaltet und an den Übertragseingang C des Addierers ADD eine logische Eins gelegt. Das Substrahieren selbst erfolgt dadurch, daß das Zweierkompliment des Speicherinhalts des Summenregisters gebildet wird. Dazu wird der Inhalt des Summenregisters RS invertiert auf die Eingänge B des Addierers ADD gelegt und über den Übertragseingang C eine logische Eins addiert. Die notwendige Division durch 2 erfolgt durch entsprechende Verdrahtung der Register RS und R. Dazu werden die den einzelnen Bitstellen zugeordneten Ausgänge des weiteren Registers R wieder um eine Wichtung versetzt auf die Eingänge des Registers R rückgeführt.

Das Rechenwerk gemäß FIG 2 arbeitet folgendermaßen. Zu Beginn der Kalibrierungsphase wird das Summenregister RS und das weitere Register R auf Null gesetzt. Der größte gewichtete Kondensator CN des Wandlernetzwerks wird mit der Summe der restlichen gewichteten Kapazitäten verglichen und damit der Fehlerterm EN ermittelt. Der Multiplexer MUX am Eingang des Rechenwerks schaltet den vom sukzessiven Approximationsregister SAR ausgegebenen Fehlerterm EN auf den Buseingang A des Addierers ADD. Von diesem Fehlerterm EN wird dann der Inhalt des Summenregisters RS, der beim ersten Kalibrierungsvorgang noch Null ist, durch Bildung des Zweierkompliments subtrahiert. Das Ergebnis der Subtraktions wird durch 2 dividiert, was beispielsweise wie beschrieben durch eine entsprechende Verdrahtung möglich ist. Der Quotient bildet den zu errechnenden Korrekturwert, der im weiteren Register R gespeichert und als errechneter Korrekturwert KWN in den Speicher Sp abgespeichert wird.

Darauf werden die Ausgänge des weiteren Registers R mit Hilfe des Multiplexers MUX auf den Buseingang A des Addierers geschaltet. Am Buseingang B des Addierers ADD liegen die Ausgänge des Summenregisters RS. Beide Werte werden addiert und ergeben das erste Zwischenergebnis, das beim ersten Kalibrierungsvorgang dem Korrekturwert KWN entspricht, der dann im Summenregister RS gespeichert wird.

Beim zweiten Durchlauf wird der zweite Fehlerterm E (N - 1) gemessen und auf den Buseingang A des Addierers gelegt. Von diesem Fehlerterm wird die Summe der im Summenregister gespeicherten Korrekturwerte subtrahiert, d.h. im Beispiel der Wert KWN. Das Ergebnis wird wie beschrieben durch 2 dividiert und der Quotient entspricht dem nächsten Korrekturwert KW (N - 1), der wieder im weiteren Register R zwischengespeichert und als zweiter Korrekturwert im Speicher Sp eingespeichert wird. Anschließend wird wieder der Inhalt beider Register R und RS addiert und als neue Zwischensumme im Summenregister RS abgelegt.

Dieses Verfahren wird solange fortgesetzt, bis alle gewichteten Kapazitäten ausgemessen und alle Korrekturwerte berechnet sind.

Bei der normalen Konversionsphase wird das Rechenwerk zum Addieren der Korrekturwerte verwendet. Am Ausgang des Kalibrier- und Korrekturnetzwerks muß ein Wert stehen, der der Summe derjenigen Korrekturwerte entspricht, die den auf logisch Eins gesetzten gewichteten Kapazitäten des Wandlernetzwerks zugeordnet sind.

Zu Beginn einer Wandlungsphase wird das Summenregister RS auf Null gesetzt. Der Multiplexer MUX schaltet bei normaler Wandlung die Bitausgänge des Speichers Sp auf den Buseingang A des Addierers ADD. Wird mit Hilfe des sukzessiven Approximationsregisters im kapazitiven Wandlernetzwerk eine Kapazität gesetzt, so wird der entsprechende Korrekturwert aus dem Speicher Sp geholt und zum Inhalt des Summenregisters RS addiert. Das Ergebnis wird am Kalibrier- und Korrekturnetzwerk ausgegeben. Bei der sukzessiven Approximation werden die Bits nacheinander, beginnend mit dem höchstwertigen Bit (MSB), getestet. Dazu wird im Wandlernetzwerk das zu untersuchende Bit auf Eins gesetzt, d.h. der zugeordnete Kondensator wird auf positive Referenzspannung geschaltet. Je nach der Entscheidung des Komparators K bleibt das Bit gesetzt oder wird auf Null zurückgeschaltet. Entsprechend wird die Addition der Korrekturwerte für die nächste Addition verwendet und als neuer Wert in das Summenregister RS eingeschrieben oder der Korrekturwert wird verworfen, so daß der Inhalt des Summenregisters RS unverändert bleibt.

Beim selbstkalibrierenden Wandler kann der nachteilige Zustand auftreten, daß der Komparator K unter Umständen kein definiertes Logikpotential ausgeben kann, d.h. daß die Entscheidung des Komparators nicht definiert ist. Das kann beispielsweise beim Übergang von einem Codewert zum nächsten, d.h. an einer Codeschwelle auftreten. Im Normalfall ergibt sich daraus kein Problem, da die Komparatorentscheidung in das sukzessive Approximationsregister SAR eingelesen wird und sich dieses Register nach einer kurzen metastabilen Zeit für eine logische Null oder eine logische Eins entscheidet. Bei dem erfindungsgemäßen Verfahren der Selbstkalibrierung, bei dem der Korrekturwert während der Wandlung mitgerechnet und die Anpassungsfehler analog korrigiert werden, kann der Fall eintreten, daß mit einer logischen Eins gerechnet wird, daß sich das sukzessive Approximationsregister SAR aber für eine logische Null entscheidet, so daß ein Wandlungsfehler entstehen würde. Um diesen metastabilen Zustand berücksichtigen zu können, ist im Rechenwerk der Zwischenspeicher L, der als Latch ausgebildet ist, vor dem Buseingang B des Addierers ADD angeordnet. Dieser Zwischenspeicher ist bei der Kalibrierungsphase transparent geschaltet. Zum Zeitpunkt jeder Bitentscheidung wird im Summenregister RS auf jeden Fall das Ergebnis der vorhergehenden Addition gespeichert. Der Zwischenspeicher ist dabei nicht transparent geschaltet. Dann wird die metastabile Zeit der im sukzessiven Approximationsregister SAR enthalteten Registerelemente abgewartet, die etwa 25 ns beträgt. Entscheidet sich dann das sukzessive Approximationsregister für eine logische Eins, wird der Zwischenspeicher für die nächste halbe Taktperiode transparent geschaltet. Auf diese Weise erreicht man, daß der berechnete Korrekturwert dem Bitmuster im sukzessiven Approximationsregister entspricht.

## Patentansprüche

1. Verfahren zur Bestimmung und Verarbeitung von Korrekturwerten für einen selbstkalibrierenden A/D- und D/A-Wandler nach dem Prinzip der sukzessiven Approximation, bei dem ein mit einem Ausgang eines Komparators (K) verbundenes sukzessives Approximationsregister (SAR) ein binär gewichtetes Wandlernetzwerk steuert, das über einen gemeinsamen Knotenpunkt mit einem Eingang des Komparators verbunden ist, und bei dem Korrekturwerte in Verbindung mit einem Rechenwerk (RW) und einem Kalibrier- und Korrekturnetzwerk erzeugt werden,
wobei in der Kalibrierungsphase, beginnend mit dem höchstwertigen Netzwerkelement (CN), für jedes gewichtete Netzwerkelement (Ci) des Wandlernetzwerks durch Vergleich mit der Summe aller niedriger gewichteten Netzwerkselemente mit Hilfe des Kalibrier- und Korrekturnetzwerks Fehlerterme (EN) gemessen werden und mit Hilfe des Rechenwerks (RW) und eines Registers (RS) für jedes gewichtete Netzwerkelement (Ti) des Wandlernetzwerks ein Korrekturwert (KWi) als die Hälfte der Differenz aus dem zugeordneten Fehlerterm (Ei) und der Summe aller Korrekturwerte (KWj, j=i+1, ..., N) für die höher gewichteten Netzwerkelemente berechnet sowie jeder berechnete Korrekturwert (KWi) in einem Speicher (Sp) gespeichert wird, und
wobei in der Wandlungsphase, beginnend mit dem höchstwertigen Netzwerkelement (CN), bei Setzen eines gewichteten Netzwerkelements (Ci) der zugehörige Korrekturwert (KWi) aus dem Speicher (Sp) ausgespeichert und für die Wandlung bereitgestellt wird,
**dadurch gekennzeichnet,**
daß das sukzessive Approximationsregister (SAR) sowohl in der Kalibrierungs- als auch in der Wandlungsphase das Rechenwerk (RW) und ein einziges Kalibrier- und Korrekturnetzwerk (KCN) derart steuert, daß das Rechenwerk und das Kalibrier- und Korrekturnetzwerk den jedem gewichteten Netzwerkelement (Ci) zugeordneten Korrekturwert (KWi) sowohl in der Kalibrierungsphase ermitteln und speichern als auch in der Wandlungsphase bereitstellen,
wobei in der Kalibrierungsphase schrittweise von jedem Fehlerterm (Ei) mit Hilfe eines Addierers (ADD) der Inhalt des Summenregisters (RS) subtrahiert, das Ergebnis mit Hilfe eines weiteren Registers (R) durch 2 dividiert und der den Korrekturwert (KWi) bildende Quotient im weiteren Register (R) zwischengespeichert wird,
wobei der im weiteren Register (R) zwischengespeicherte Korrekturwert (KWi) zum Inhalt des Summenregisters (RS) addiert und als neuer Wert im Summenregister (RS) zwischengespeichert wird und
wobei der Inhalt des Summenregisters (RS) über einen steuerbaren Zwischenspeicher (L) in den Addierer (ADD) einlesbar ist, der von einer Ablaufsteuerung (AST) während der Kalibrierungsphase transparent geschaltet wird und in der Wandlungsphase während einer Bitentscheidung des sukzessiven Approximationsregisters (SAR) nicht transparent geschaltet wird mit Ausnahme einer getroffenen Bitentscheidung des sukzessiven Approximationsregisters (SAR) für eine logische Eins, die eine kurzzeitige transparente Durchschaltung bewirkt.

2. Verfahren nach Anspruch 1, **dadurch gekennzeichnet**, daß die Subtraktion durch Addition des Zweierkompliments des Inhalts des Registers (RS) erfolgt.

3. Rechenwerk zur Bestimmung und Verarbeitung von Korrekturwerten für einen selbstkalibrierenden A/D- und D/A-Wandler nach dem Prinzip der sukzessiven Approximation, welcher einen Komparator (K) sowie ein mit einem Ausgang des Komparators (K) verbundenes sukzessives Approximationsregister (SAR) und ein letzterem nachgeschaltetes binär gewichtetes Wandlernetzwerk enthält, das über einen gemeinsamen Knotenpunkt mit einem Eingang des Komparators verbunden ist, wobei das Rechenwerk einen Addierer (ADD) und ein mit einem Eingang und einem Ausgang des Addierers verbundenes Register (RS) enthält,
dadurch gekennzeichnet,
daß dem Addierer ein weiteres Register (R) nachgeschaltet ist und daß der Addierer an einem anderen Eingang über einen Multiplexer MUX mit dem weiteren Register (R), dem sukzessiven Approximationsregister (SAR) und einem Speicher (Sp) für Korrekturwerte verbindbar ist, wobei eine Ablaufsteuerung (AST) in Verbindung mit dem sukzessiven Approximationsregister (SAR) die Steuerung des Rechenwerks übernimmt.

4. Rechenwerk nach Anspruch 3, **dadurch gekennzeichnet**, daß zwischen die Ausgänge des Registers (RS) und die zugeordneten Addierereingänge (B) eine Exklusiv-ODER-Logik (XOL) geschaltet ist und der Addierer (ADD) einen weiteren Übertragseingang (C) aufweist.

5. Rechenwerk nach Anspruch 4, **dadurch gekennzeichnet**, daß der Exklusiv-ODER-Logik (XOL) ein vom Komparator (K) des Wandlers Steuerbarer Zwischenspeicher (L) nachgeschaltet ist.

## Claims

1. Method for determining and processing correction values for a self-calibrating A/D and D/A converter in accordance with the principle of successive approximation, in which a successive approximation register (SAR) connected to an output of a comparator (K) controls a binary-weighted converter network which is connected via a common node to an input of the comparator, and in which correction values are produced in conjunction with an arithmetic unit (RW) and a calibration and correction network,
in the calibration phase, beginning with the most-significant network element (CN), the calibration and correction network being used to measure error terms (EN) for each weighted network element (Ci) of the converter network, by comparison with the sum of all of the lower-weighted network elements, and the arithmetic unit (RW) and a register (RS) being used to calculate a correction value (KWi) for each weighted network element (Ti) of the converter network as half of the difference between the assigned error term (Ei) and the sum of all of the correction values (KWj, j=i+1, ..., N) for the higher-weighted network elements, and each calculated correction value (KWi) being stored in a memory (Sp), and
in the conversion phase, beginning with the most-significant network element (CN), in the event of a weighted network element (Ci) having been set, the associated correction value (KWi) being read from the memory (Sp) and being made available for the conversion, characterized
in that the successive approximation register (SAR) controls the arithmetic unit (RW) and a single calibration and correction network (KCN), both in the calibration phase and in the conversion phase, in such a way that the arithmetic unit and the calibration and correction network both determine and store the correction value (KWi), assigned to each weighted network element (Ci), in the calibration phase and make the said correction value available in the conversion phase,
in the calibration phase, the contents of the summation register (RS) being subtracted, in steps, from each error term (Ei) with the aid of an adder (ADD), the result being divided by 2 with the aid of a further register (R), and the quotient forming the correction value (KWi) being temporarily stored in the further register (R),
the correction value (KWi) temporarily stored in the further register (R) being added to the contents of the summation register (RS) and being temporarily stored as a new value in the summation register (RS), and
it being possible to read the contents of the summation register (RS) via a controllable buffer (L) into the adder (ADD), which is connected transparently during the calibration phase by a sequence controller (AST) and is connected non-transparently in the conversion phase during a bit decision of the successive approximation register (SAR), with the exception of a bit decision made by the successive approximation register (SAR) in favour of a logic one, which effects brief, transparent through-connection.

2. Method according to Claim 1, characterized in that the subtraction is carried out by addition of the two's complement of the contents of the register (RS).

3. Arithmetic unit for determining and processing correction values for a self-calibrating A/D and D/A converter in accordance with the principle of successive approximation, which contains a comparator (K), as well as a successive approximation register (SAR) connected to an output of the comparator (K), and a binary-weighted converter network which is connected downstream of the said register and is connected via a common node to an input of the comparator, the arithmetic unit containing an adder (ADD) and a register (RS) connected to an input and an output of the adder,
characterized
in that a further register (R) is connected downstream of the adder, and in that the adder can be connected at another input, via a multiplexer (MUX), to the further register (R), the successive approximation register (SAR) and a memory (Sp) for correction values, a sequence controller (AST) in conjunction with the successive approximation register (SAR) undertaking the control of the arithmetic unit.

4. Arithmetic unit according to Claim 3, characterized in that an exclusive-OR logic device (XOL) is connected between the outputs of the register (RS) and the assigned adder inputs (B), and the adder (ADD) has a further carry input (C).

5. Arithmetic unit according to Claim 4, characterized in that a buffer (L) which can be controlled by the comparator (K) of the converter is connected downstream of the exclusive-OR logic device (XOL).

## Revendications

1. Procédé de détermination et de traitement de valeurs de correction pour un convertisseur analogique/numérique et numérique/analogique à auto-étalonnage, selon le principe des approximations successives, selon lequel un registre d'approximations successives (SAR), qui est relié à une sortie d'un comparateur (K), commande un réseau de convertisseur pondéré de manière binaire, qui est relié par l'intermédiaire d'un noeud commun à une entrée du comparateur, et selon lequel on produit des valeurs de correction en liaison avec une unité de calcul (RW) et un réseau d'étalonnage et de correction, et
selon lequel pendant la phase d'étalonnage, en commençant par l'élément de poids le plus grand (CN) du réseau, on mesure, pour chaque élément pondéré (Ci) du réseau de convertisseur, des termes d'erreur (EN) par comparaison à la somme de tous les éléments à pondération plus petite du réseau, à l'aide du réseau d'étalonnage et de correction, et on calcule, à l'aide de l'unité de calcul (RW) et d'un registre (RS) pour chaque élément pondéré (Ti) du réseau de convertisseur, une valeur de correction (KWi) égale à la moitié de la différence entre le terme d'erreur associé (Ei) et la somme de toutes les valeurs de correction (KWj, j=i+1, ..., N) pour les éléments à pondération plus grande du réseau, et on mémorise chaque valeur de correction calculée (KWi) dans une mémoire (Sp), et
selon lequel, pendant la phase de conversion, en commençant par l'élément de poids maximum (CN) du réseau, lors du positionnement d'un élément pondéré (Ci) du réseau, on extrait de la mémoire (Sp) la valeur de correction associée (AWi) et on la prépare pour la conversion,
caractérisé par le fait
que le registre d'approximations successives (SAR) commande, aussi bien pendant la phase d'étalonnage que pendant la phase de conversion, l'unité de calcul (RW) et un seul réseau d'étalonnage et de correction (KCN), de telle sorte que l'unité de calcul et le réseau d'étalonnage et de correction déterminent et mémorisent la valeur de correction (KWi), associée à chaque élément pondéré (Ci) du réseau pendant la phase d'étalonnage et la préparent également pendant la phase de conversion,
pendant la phase d'étalonnage, on soustrait pas-à-pas de chaque terme d'erreur (Ei) le contenu du registre de somme (RS) à l'aide d'un additionneur (ADD), on divise par 2 le résultat à l'aide d'un autre registre (R) et on mémorise temporairement le quotient, qui forme la valeur de correction (KWi), dans l'autre registre (R), et
on additionne la valeur de correction (KWi) mémoriséee temporairement dans l'autre registre (R) au contenu du registre de somme (RS) et on mémorise le résultat temporairement en tant que nouvelle valeur dans le registre de somme (RS), et
on peut introduire le contenu du registre de somme (RS), par l'intermédiaire d'une mémoire intermédiaire commandable (L) dans l'additionneur (ADD), que l'on rend transparent par une unité (AST) de commande de déroulement pendant la phase d'étalonnage et que l'on ne rend pas transparent pendant la phase de conversion pendant une décision sur un bit du registre d'approximations successives (SAR), à l'exception d'une décision associée prise concernant un bit du registre d'approximations successives (SAR) pour un un logique, qui déclenche une transmission transparente de brève durée.

2. Procédé suivant la revendication 1, caractérisé par le fait que la soustraction s'effectue par addition du complément à deux du contenu du registre (RS).

3. Unité de calcul pour la détermination et le traitement de valeurs de correction pour un convertisseur analogique/numérique et numérique/ analogique à auto-étalonnage, selon le principe des approximations successives, qui comprend un comparateur (K) ainsi qu'un registre d'approximations successives (SAR), qui est relié à une sortie du comparateur (K) et un réseau de convertisseur pondéré de manière binaire, qui est branché en aval du registre d'approximations successives et qui est relié par l'intermédiaire d'un noeud commun à une entrée du comparateur, l'unité de calcul conprenant un additionneur (ADD) et un registre (RS) relié à une entrée et à une sortie de l'additionneur,
caractérisée par le fait
qu'un autre registre (R) est branché en aval de l'additionneur et que l'additionneur peut être relié, par une autre entrée, par l'intermédiaire d'un multiplexeur (MUX), à l'autre registre (R), au registre d'approximations successives (SAR) et à une mémoire (Sp) de valeurs de correction, l'unité de commande de déroulement (AST) prenant en charge, en liaison avec le registre d'approximations successives (SAR), la commande de l'unité de calcul.

4. Unité de calcul suivant la revendication 3, caractérisée par le fait qu'une logique OU-Exclusif (XOL) est branchée entre les sorties du registre (RS) et les entrées associées (B) de l'additionneur et que l'additionneur (ADD) comporte une autre entrée de report (C).

5. Unité de calcul suivant la revendication 4, caractérisée par le fait qu'une mémoire intermédiaire (L) pouvant être commandée par le comparateur (K) du convertisseur est branchée en aval de la logique OU-Exclusif (XOL).
